# EUROPEAN PATENT APPLICATION

(11) **EP 1 760 773 A1**
(43) Date of publication of application: **07.03.2007**
(21) Application number: 05753439.8
(22) Date of filing: 22.06.2005
(51) Int. Cl.: H01L 21/68, H01L 21/301, H01L 21/52

(54) **SHEET PEELING DEVICE AND METHOD**

(30) Priority: 25.06.2004 JP 2004187518
(71) Applicant: Lintec Corporation, Tokyo 173-0001 (JP)
(72) Inventor: TSUJIMOTO, Masaki, Lintec Corporation, Tokyo 1730001 (JP); YOSHIOKA, Takahisa, Lintec Corporation, Tokyo 1730001 (JP); KOBAYASHI, Kenji, Lintec Corporation, Tokyo 1730001 (JP)
(74) Representative: Grünecker, Kinkeldey, Stockmair & Schwanhäusser Anwaltssozietät
(86) International application number: PCT/JP2005/011408
(87) International publication number: WO 2006/001289

(57) **Abstract**

A sheet peeling apparatus 50 which, after sticking a web material LS laminated with heat sensitive adhesive type adhesive sheet S on a release liner PS to a semiconductor wafer W, cuts the web material along the periphery of a semiconductor wafer and peels off a release liner PS portion positioned on the semiconductor wafer and a web material portion S1 positioned at the periphery side around the semiconductor wafer. The apparatus is equipped with a roll 135 capable of performing a relative movement with respect to the table 47 supporting the wafer W, and is arranged to stick a peeling tape ST to the web material LS with the roll, and then winds to peel off the tape; thus, only the adhesive sheet S is left on the wafer W.

## Description

### [Technical field]

The present invention relates to a sheet peeling apparatus and a peeling method, in particular, to a sheet peeling apparatus and a peeling method suitable for peeling off or removing portions of the web material excluding the adhesive sheet on the semiconductor wafer, after an adhesive sheet is stuck to a semiconductor wafer using a web material laminated with a heat sensitive adhesive sheet on a release liner.

### [Background Art]

It has been conventionally performed that a semiconductor wafer (hereinafter, simply referred as "wafer") formed with a circuit plane is separated into individual chips, thereafter each of the chips is picked up and bonded to a lead frame (die bonding). The die bonding is carried out after a heat sensitive adhesive sheet for die bonding is stuck to a wafer beforehand in wafer-processing steps.

As disclosed in patent document 1 for instance, the adhesive sheet is stuck to the wafer using a web material, which is laminated with an adhesive sheet on a release liner. The web material is paid out to the wafer and pressed with a press roll. After this sticking operation is carried out, the web material is cut by a cutter turned along the periphery of the wafer. And a peeling roll is made to go through between the web material and the wafer to collect the web material around the wafer. And then, a peeling tape is stuck to the release liner, which is left on the wafer in accordance with the shape of the wafer to wind the peeling tape. Thus, only the release liner can be peeled off in a state that the adhesive sheet is left on the wafer.

[Patent Document 1] Japanese Patent Application Laid-open No. 2003-257898

### [Disclosure of the invention]

### [Problems to be Solved by the Invention]

However, in the structure disclosed in the patent document 1, the following two steps are required; i.e., a step to remove the web material around the wafer, and a step to peel off the release liner from the portion of the web material stuck to the wafer. Therefore, there resides such a disadvantage that a device for removing the web material around the wafer and a peeling device for removing the release liner from the portion of the web material stuck on the wafer are required, resulting in an extremely complicated structure of the apparatus. Further, by carrying out the steps using the devices as described above, the period of time for wafer processing is elongated causing deterioration of processing efficiency.

### [Object of the Invention]

The present invention has been proposed in view of the above disadvantage. An object of the present invention is to provide a sheet peeling apparatus and a peeling method, which are capable of peeling off efficiently unnecessary portion after sticking an adhesive sheet to a plate-like object, and allowing the structure of the apparatus to be simplified resulting in reduction of processes of the plate-like object.

### [Means for Solving the problem]

In order to achieve the object, the present invention adopts such an arrangement that a sheet peeling apparatus, which, after paying out a web material laminated with an adhesive sheet on one surface of a release liner and sticking the adhesive sheet to a plate-like object, cuts the web material along the periphery of the plate-like object and peels off a release liner portion positioned on the plate-like object along with a web material portion positioned on the periphery side around the plate-like object, is provided with,
a stick and winding section for a peeling tape, wherein the stick and winding section winds the peeling tape in a state that the peeling tape is stuck crossing the release liner positioned on the plate-like object and the release liner positioned at the periphery side, whereby peels off simultaneously the release liner positioned on the plate-like object along with the web material portion positioned at the periphery side.

Also, the present invention may adopt such an arrangement that a sheet peeling apparatus, which, after paying out a web material continuing in a band-like shape laminated with a heat sensitive adhesive sheet on one surface of a release liner and sticking the adhesive sheet to a plate-like object, cuts the web material in the width direction to a sheet-like shape and cuts the web material along the periphery of the plate-like object, and peels off the release liner positioned on the plate-like object along with a web material portion positioned at the periphery side of the plate-like object, is provided with,
a stick and winding section for a peeling tape, wherein the stick and winding section winds the peeling tape in a state that the peeling tape is stuck crossing the release liner positioned on the plate-like object and the release liner positioned at the periphery side, whereby peels off simultaneously the release liner positioned on the plate-like object along with the web material portion positioned at the periphery side.

The present invention may be arranged so that the stick and winding section includes a roll capable of performing a relative movement with respect to a table supporting the plate-like object, the roll having a function to rotate on the web material to stick a peeling tape on the release liner in a state that the peeling tape is wound on the periphery thereof, and a function to rotate in the opposite direction to the rotation to carry out the peeling operation.

Also, the peeling tape is preferably formed with a width smaller than the diameter of the plate-like object.

Further, the plate-like object may be a semiconductor wafer.

Furthermore, the present invention adopts such a sheet peeling method that, after paying out a web material laminated with an adhesive sheet on one surface of a release liner and sticking the adhesive sheet to a plate-like object, the web material is cut along the periphery of the plate-like object and a release liner portion positioned on the plate-like object is peeled off along with a web material portion positioned on the periphery side around the plate-like object, comprising the steps of:
sticking a peeling tape crossing release liner positioned on the plate-like object and release liner positioned at the periphery side, and
peeling off, through winding the peeling tape, of the release liner positioned on the plate-like object along with the web material positioned at the periphery side while winding simultaneously keeping the adhesive sheet left on the plate-like object.

Still further, the plate-like object in the sheet peeling method may be a semiconductor wafer.

### [Effects of the Invention]

According to the present invention, such an arrangement is adopted that the release liner positioned on the plate-like object and the web material portion at the periphery side can be peeled off or removed simultaneously. Therefore, peeling operation can be carried out without employing complicated apparatus resulting in reduction of processing time.
Further, such an arrangement is adopted that a roll, which is capable of performing a relative movement with respect to the table for supporting the plate-like object, plays both functions of sticking the peeling tape and winding the same. In this point also, the number of the component parts of the apparatus can be reduced. Furthermore, positional interference with other component parts, which tends to occur while the roll performs a relative movement, hardly occurs, and the degree of freedom in layout of the structural parts can be expanded.
Still further, since a peeling tape with narrow width can be employed, waste volume of the material can be restrained as well.

### [Brief Description of the Drawings]

[Fig. 1]

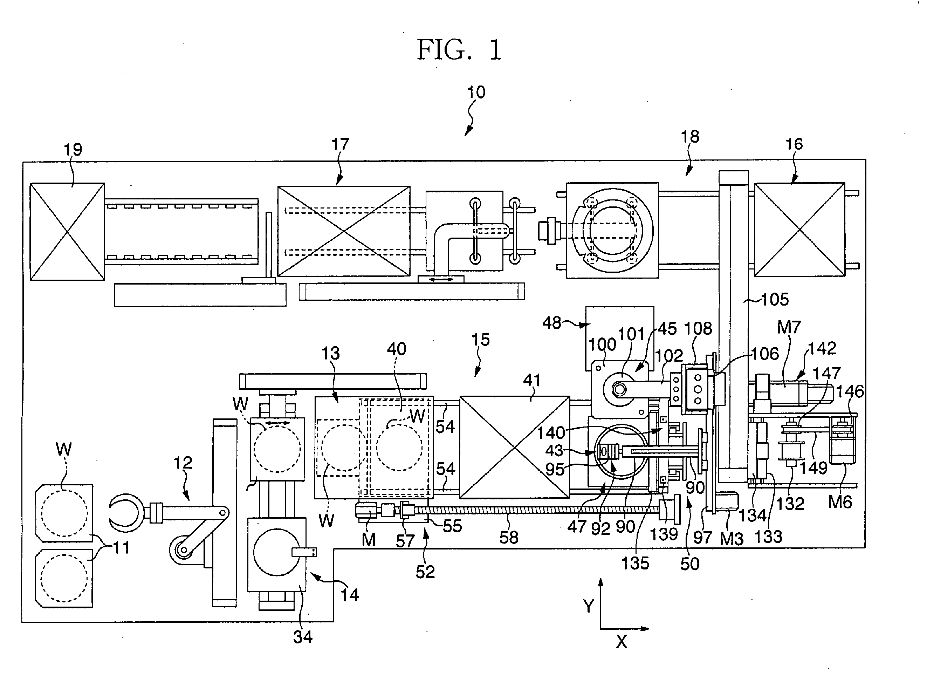

   Fig. 1 is a plan view schematically showing the entire structure of a wafer processing system to which a sheet peeling apparatus and a peeling method in accordance with an embodiment of the present invention is applied.
[Fig. 2]

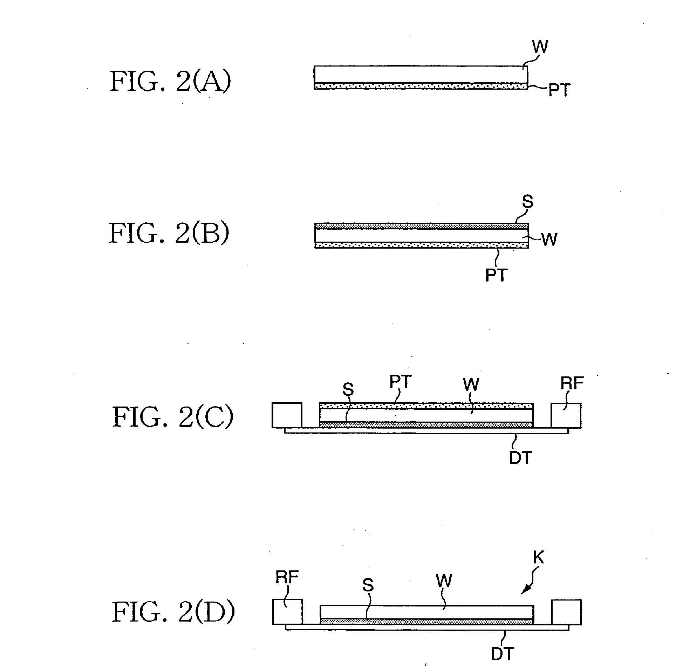

   Fig. 2 is a schematic sectional view for illustrating wafer-processing steps on the basis of time lapse.
[Fig. 3]

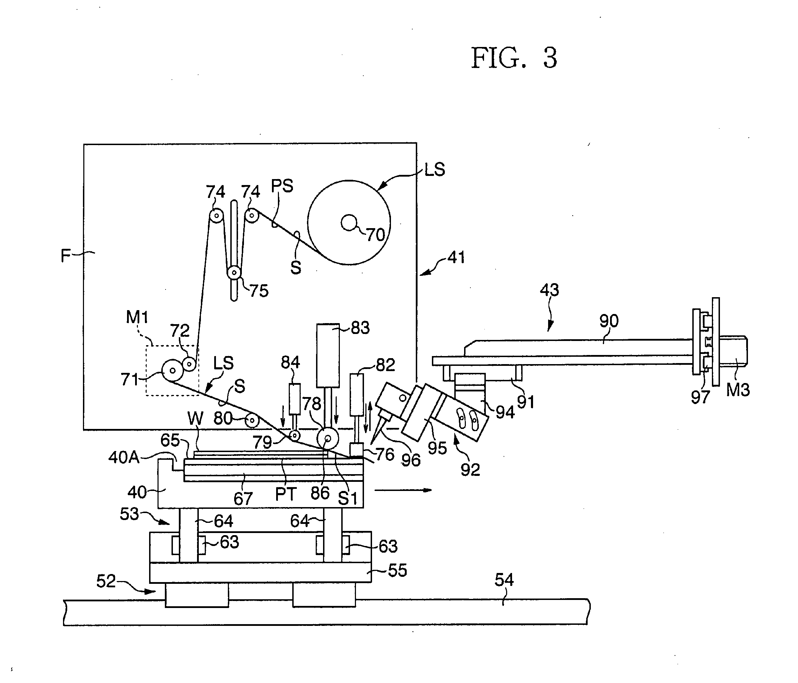

   Fig. 3 is a front view schematically showing an initial stage in temporarily attaching adhesive sheet of a web material.
[Fig. 4]

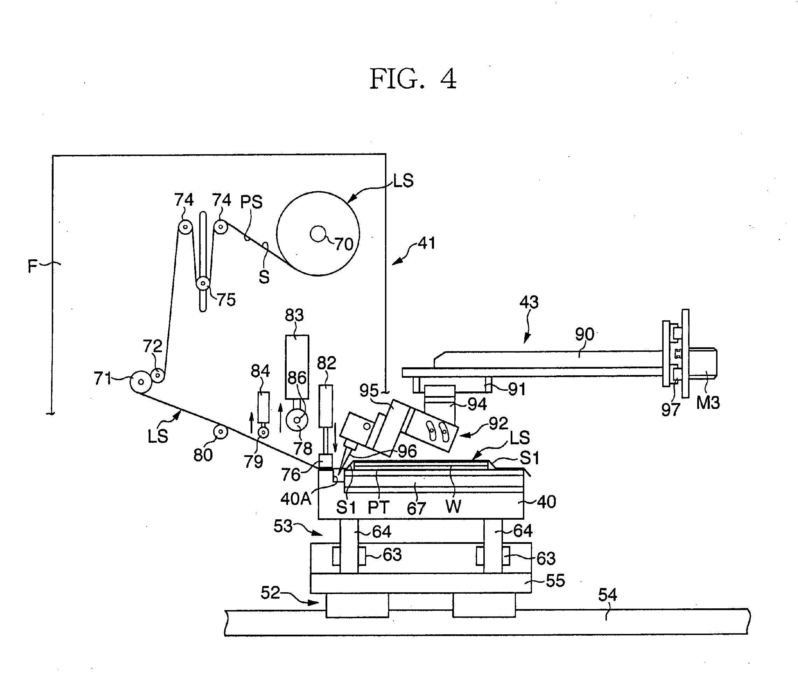

   Fig. 4 is a schematic front view of cutting operation of the web material in the width direction thereof after temporarily attaching the adhesive sheet.
[Fig. 5]

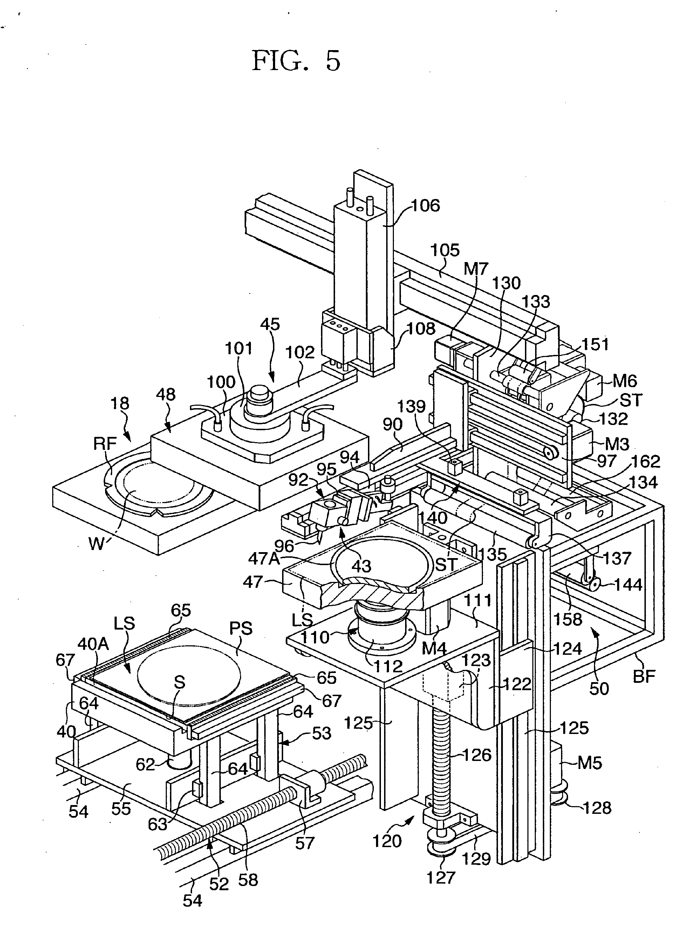

   Fig. 5 is a perspective view schematically showing the principal part of the embodiment of the present invention.
[Fig. 6]

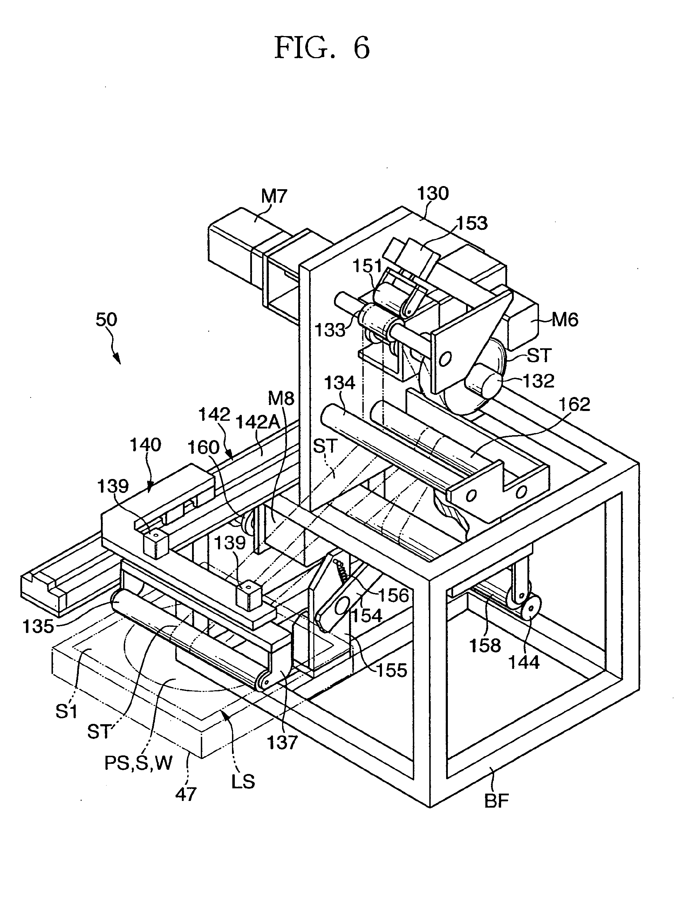

   Fig. 6 is an enlarged perspective view schematically showing the sheet peeling apparatus.
[Fig. 7]

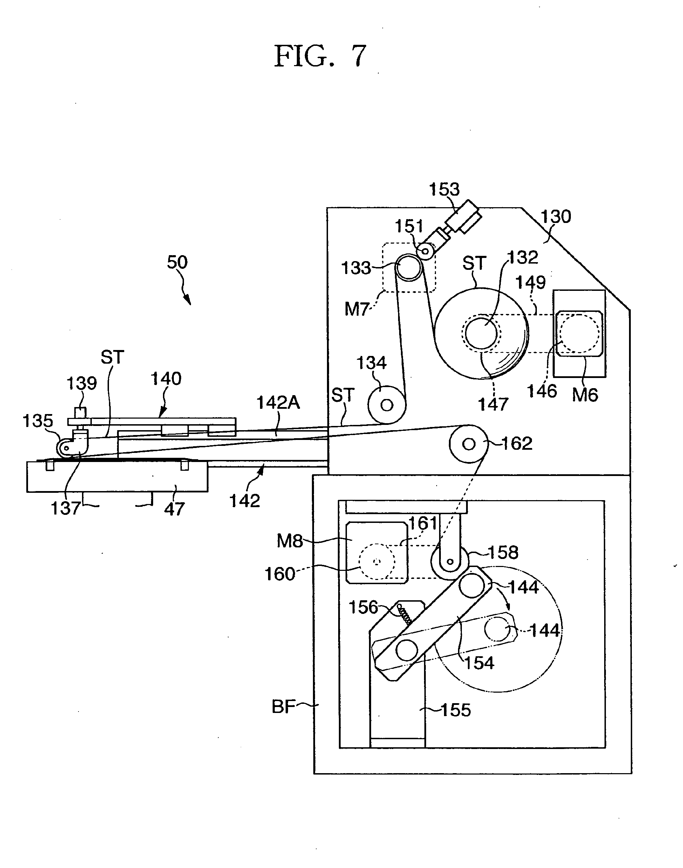

   Fig. 7 is a front view schematically showing the sheet peeling apparatus.
[Fig. 8]

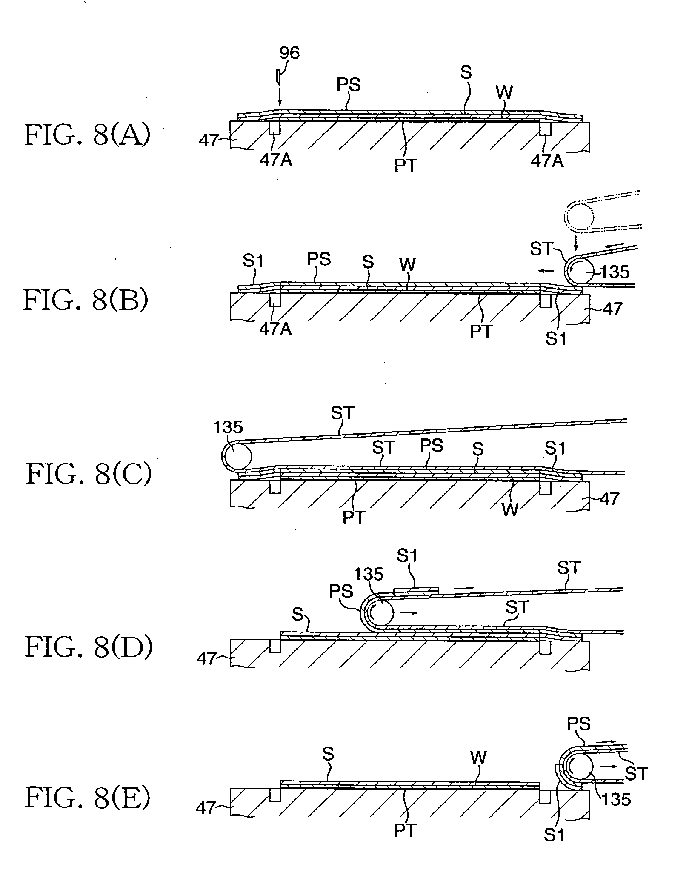

   Figs. 8(A) to 8(E) are sectional views schematically showing peeling steps using the sheet peeling apparatus.

### [Explanation of Reference Numerals]

- 47: periphery cutting table
- 50: sheet peeling apparatus
- 135: roll comprising a sticking and winding section
- PS: release liner
- S: adhesive sheet (heat sensitive adhesive sheet)
- S1: unnecessary portion of web material
- LS: web material
- W: semiconductor wafer

### [Best Mode for Carrying Out the Invention]

Hereinafter, an embodiment of the present invention will be described with reference to drawings.

Fig. 1 is a plan view of a wafer processing system relevant to an embodiment to which a sheet peeling apparatus and a peeling method of the present invention is applied. Fig. 2 is a schematic sectional view for illustrating wafer-processing steps on the basis of time lapse. Referring to these figures, the wafer processing system 10 is structured as an apparatus that handles a wafer W as an object, which is attached with a UV cure protection tape PT (refer to Fig. 2) over a surface serving as a circuit surface. After attaching a heat sensitive adhesive sheet S (hereinafter referred to as "adhesive sheet S") for die bonding to the rear surface of the wafer W, the wafer processing system 10 performs a series of process to mount the wafer W on a ring frame RF via a dicing tape DT interposed therebetween.

As shown in Fig. 1, the wafer processing system 10 includes, cassettes 11 that accommodate wafers W; a robot 12 that sucks and holds a wafer W taken out from a cassette 11; a UV irradiation unit 13 that irradiates the protection tape PT with UV light; an alignment unit 14 that positions the wafer W; a sticking device 15 that sticks the adhesive sheet S (refer to Fig. 2) to the rear surface of the aligned wafer W; a mount unit 18, including a tape sticking unit 16 that sticks a dicing tape DT to a wafer W which has already been stuck with the adhesive sheet S thereon and mounts the wafer W on the ring frame RF and a tape peeling unit 17 that peels off the protection tape PT; and a stocker 19 that stores wafers W from which the protection tape PT has been peeled off.

The structure other than the sticking device 15 is substantially identical to what disclosed in Japanese Patent Application No. 2004-133069 filed by the applicant of the present invention and performs the identical operation. Therefore, hereinafter, only the sticking device 15 that is different from the above application will be described.

As shown in Fig. 3 and Fig. 4, the sticking device 15 is arranged so that it has a function to stick a web material LS laminated with adhesive sheet S on one surface of a release liner PS to the wafer W, and a function to peel off the redundant portion or area of the web material LS to keep the adhesive sheet S left on the wafer W. The sticking device 15 is arranged to include a sticking table 40 supporting the wafer W, a sticking unit 41 to attach temporarily the adhesive sheet S to the rear surface side (upper face side) of the wafer W sucked by the sticking table 40, a cutting means 43 to cut the web material LS in the width direction thereof into a sheet-like shape for each wafer W, a transfer unit 45 to suck and transfer the wafer W from the sticking table 40 (refer to Fig. 1), a periphery cutting table 47 that sucks and supports the wafer W transferred by the transfer unit 45 to cut an unnecessary portion of the web material S1 (refer to Fig. 6) extending over the periphery side of the wafer W with the cutting means 43 (refer to Fig. 5), a bonding table 48 disposed adjacent to the periphery cutting table 47 for completely bonding the temporarily attached adhesive sheet S to the wafer W, and a sheet peeling apparatus 50 that peels off the release liner PS on the wafer W and the unnecessary portion of the web material S1 simultaneously (refer to Fig. 5).

The sticking table 40 is arranged so that the upper face side thereof is a suction face and maintains the sheet to a first temperature at which the adhesive sheet S can be melt to a certain extent and temporarily attached to the wafer W; in this embodiment, to approximately 110°C. The sticking table 40 is arranged to include an inner table section and an outer table section surrounding the inner table section (illustration is omitted). The inner table section is formed to be a plane shape substantially identical to that of the wafer W for serving as a supporting face of the wafer W and arranged to maintain the wafer W to approximately 110°C. The outer table section is arranged to maintain the temperature thereof to lower than that of the inner table section; in this embodiment, to approximately 40°C. Owing to this arrangement, the unnecessary portion of the web material S1 extending to the outside of the wafer W is attached to the outer table section with a weak adhesive strengh; and thus, when the adhesive sheet S is stuck to the wafer W, the wafer W is prevented from forming wrinkles thereon.

Further, the sticking table 40 is arranged to reciprocate between two positions via a shifter 52; i.e., a position where a wafer W is received from the UV irradiation unit 13 and a position above the periphery-cutting table 47 passing below the area of the sticking unit 41. Further, the sticking table 40 is arranged to be movable vertically via a lift 53. As shown in Fig. 5, the shifter 52 includes a pair of rails 54, 54, a slide plate 55 moving on the rails 54 being guided by these rails 54, a ball spline shaft 58 that goes through a bracket 57, which is fixed to the slide plate 55, being engaged with the bracket 57, and a motor M that drives to rotate the ball spline shaft 58 (refer to Fig. 1). Owing to the forward and reverse rotation of the motor M, the sticking table 40 reciprocates in right and left directions in Fig. 1 along the rails 54. The lift 53 is provided with a vertical shift mechanism 62 disposed in a central area under the bottom face of the sticking table 40, a guide block 63 fixed to the slide plate 55 and four foot members 64 vertically movable along the guide block 63. The lift 53 is arranged so that, when the vertical shift mechanism 62 moves along the vertical direction, the sticking table 40 moves up and down to receive the wafer W from the upper stream side of the wafer processing.

In the upper face of the sticking table 40, a cutter receiving groove 40A for cutting off the web material LS in the width diriection thereof paid out from the sticking unit 41 is formed, and in the upper portion of the both sides along the shifting direction of the sticking table 40, a rack 65 and a guide bar 67 attached to the outer face of the rack 65 are provided.

As shown in Fig. 3 and Fig. 4, the sticking unit 41 is provided in the area of a plate-like frame F disposed above the sticking table 40. The sticking unit 41 includes a support roll 70 supporting the web material LS wound in a roll state to supply the material LS, a drive roll 71 and a pinch roll 72 that imparts the pay-out force to the web material LS, two guide rolls 74, 74 disposed between the support roll 70 and the pinch roll 72 and a dancer roll 75 provided between the guide rolls 74, 74, a pressurizing member 76 that pressurizes the lead end area of the web material LS against the upper face of the sticking table 40, a press roll 78 that temporarily attaches the web material LS to the rear surface side (upper face side in Fig. 3) of the wafer W successively, a tension roll 79 disposed in a position immediately before the press roll 78 in the feeding direction of the web material LS and a guide roll 80. The press roll 78 includes a heater as a heating means. Also, the bottom face side of the pressurizing member 76 has a suction portion to suck and hold the end portion of the web material LS.

The drive roll 71 is arranged to be driven to rotate by the motor M1 provided at the back side of the frame F. The pressurizing member 76, the press roll 78 and the tension roll 79 are arranged movable in the vertical direction by cylinders 82, 83 and 84 respectively. Although detailed structure is not shown in the figures, the press roll 78 is provided with a pair of pinions engaging with the racks 65 at the both ends of the rotational center shaft 86 and a pair of rollers disposed further outside of the pinions to rotate on the guide bars 67 (refer to Japanese Patent Application No. 2004-133069).

The cutting means 43 includes an arm 90, extending along the shifting direction of the sticking table 40, and a cutter unit 92 disposed on the bottom surface at the front end side (left end side in Fig. 3) of the arm 90, movably forward/backward by an uniaxial robot 91. The cutter unit 92 includes a cylinder 95 for moving the cutter vertically supported by the bracket 94, which moves along the uniaxial robot 91, and a cutter 96 attached to the front end of the cylinder 95 for vertical cutter movement. The cylinder 95 for vertical cutter movement is attached to the bracket 94 in a rotatable state within a substantially vertical plane. Owing to this, the angle of the cutter blade can be adjusted in a state that the end position of the cutter 96 is pursuing an arc trace within the substantially vertical plane, the cutter 96 can be set not to allow the adhesive sheet S to extrude out of the wafer W when performing the circumference cutting, which will be described later, and is movably along the extending direction of the arm 90 by the uniaxial robot 91. As shown in Fig. 1, the cutting means 43 is supported movably by the motor M3 driving on a guide 97 oriented to the direction perpendicular to shifting direction of the sticking table 40 (Y-direction in Fig. 1). Accordingly, the cutter 96 is maintained at a posture in which the front end thereof enters a cutter receiving groove 40A on the sticking table 40. Thus, when the entire cutting means 43 moves along the guide 97, the web material LS is cut in the width direction and the web material LS of a band-like shape is formed into a sheet for each wafer W.

As shown in Fig. 5, the transfer unit 45 includes a plate shaped suction plate 100 which sucks the wafer W at the bottom face side, a temperature control unit 101 provided at the upper face side of the suction plate 100, an arm 102 that supports the suction plate 100 and an uniaxial robot 105 that moves the arm 102 in the Y-direction. The suction plate 100 has such a function as, when the wafer W is sucked after the web material LS is cut in the width direction into the sheet-like shape on the sticking table 40, cooling down the wafer W having a first temperature (110°C) for temporarily sticking, to a temperature, for example, of an ambient temperature to reduce or eliminate the viscosity of the adhesive sheet *S; thus the adhesive agent is prevented from transferring to the cutter 96. Also, the transfer unit 45 has a function to transfer the wafer W from the sticking table 40 to the periphery cutting table 47, and to transfer the wafer W from the periphery cutting table 47 to the bonding table 48, and further, to transfer the wafer W to the next process after the adhesive sheet S is completely stuck thereto on the bonding table 48. The transfer unit 45 is arranged to control the temperature of the wafer W with the temperature control unit 101 in any of the following steps; i.e., while transferring the wafer W from the sticking table 40 to the periphery-cutting table 47, while transferring the wafer W from the periphery cutting table 47 to the bonding table 48 and while transferring the wafer W from the bonding table 48 to the mounting unit 18; thus, the time for controlling the temperature after transferring the wafer can be reduced or eliminated.

As shown in Fig. 5, the uniaxial robot 105 is disposed in an area above the guide 97 of the cutting means 43 substantially parallel to the guide 97. The uniaxial robot 105 is provided with a cylinder 106 extending in the vertical direction perpendicular to the direction of the uniaxial robot 105, and a lift slider 108, which is movable in the vertical direction by the cylinder 106. The base end side (right end side in Fig. 5) of the arm 102 is connected to the lift slider 108.

The periphery cutting table 47 is a table for receiving the wafer W from the sticking table 40 via the transfer unit 45 and sucking the same to cut the unnecessary portion S1 of the web material around the wafer W with the cutting means 43. Also, the periphery-cutting table 47 is a table for supporting the wafer W at a fixed position when peeling off the release liner PS and the unnecessary portion S1 of the web material on the wafer W simultaneously with the sheet peeling apparatus 50, which is described in detail later. According to this embodiment, the periphery-cutting table 47 is to be maintained to the ambient temperature as a second temperature; the upper face thereof is formed as a suction face and is provided with a circumference groove 47A corresponding to the peripheral edge of the wafer W. The periphery cutting table 47 is supported on the lift plate 111 via a rotary mechanism 110 that is driven by the motor M4 at the bottom face side thereof, the table 47 being arranged rotatable in a plane. Accordingly, when the cutter 96 enters into the circumference groove 47A and the periphery cutting table 47 is rotated, cutting function of the web material LS in the periphery direction; i.e., a circumference cut is achieved. The cutting in the periphery direction can be also achieved by arranging the cutter unit 92 to be rotatable within a horizontal plane.

The lift plate 111 supporting the periphery cutting table 47 is arranged to be movable in the vertical direction by a lift unit 120. As shown in Fig. 5, the lift unit 120 includes a block 123 that is attached to the backside of a support member 122 having a substantially L-like shape, which supports the lift plate 111, a pair of lift side plates 124 connected to the both sides of the support member 122, a pair of uprising guides 125 that guide these lift side plates 124 in the vertical direction, a screw shaft 126 that extends through the block 123 in the vertical direction, pulleys 127 and 128 each fixed to the lower end of the screw shaft 126 and the output shaft of a motor M5 disposed adjacent to the lower end of the uprising guides 125 and a belt 129 laid around these pulleys 127 and 128. Rotation of the screw shaft 126 by the motor M5 enables the vertical movement of the periphery cutting table 47.

The bonding table 48 is disposed in a side area above the periphery cutting table 47 via an unshown frame. The bonding table 48 is arranged so that the upper face is formed as a suction face, the wafer W is transferred from the periphery cutting table 47 by the transfer unit 45, and the wafer W, which is stuck temporarily with the adhesive sheet S, is heated to stick the adhesive sheet S completely to the wafer W. In this embodiment, the bonding table 48 is controlled to approximately 180°C as a third temperature.

As shown in Fig. 6, the sheet peeling apparatus. 50 is disposed at the side of the periphery cutting table 47. The sheet peeling apparatus 50 is arranged as a device for peeling off the release liner PS and the unnecessary portion of web material S1 simultaneously in the following manner. That is, as for the web material LS stuck on the wafer W on the periphery cutting table 47, a peeling tape ST is stuck to the release liner PS positioned on the wafer W and the unnecessary portion of web material S1 positioned at the periphery side of the wafer W, and thus, the both are wound simultaneously. As for the peeling tape ST, a peeling tape of a band-like shape having a considerably small width relative to the diameter of the wafer W is employed. That is, the width of the peeling tape is set to a width with which the peeling, to be described later, can be carried out without any disadvantage. Owing to this, the material consumption can be managed in restrained manner.

The sheet peeling apparatus 50 will be described further in detail. As shown in Fig. 6, the sheet peeling apparatus 50 is arranged to include: a base frame BF formed to a substantially cuboid in external shape by combining column members with rectangular section vertically and horizontally; a supporting plate 130 disposed within a substantially vertical plane in an upper portion of the base frame BF; a pay-out roll 132 that supports the peeling tape ST of a roll shape, which is supported rotatably by the supporting plate 130 so as to pay out the peeling tape ST; an upper guide roll 133 and a lower guide roll 134 for guiding the peeling tape ST paid out from the pay-out roll 132; a roll 135 composing a stick and winding section, which has the following two functions, i.e., a function to stick the peeling tape ST paid out via the lower guide roll 134 crossing the unnecessary portion of web material S1 and the release liner PS on the wafer and a function to wind the stuck peeling tape ST; a support arm 140 equipped with a cylinder 139 for moving a bracket 137 in the vertical direction, which rotatably supports the roll 135 at the both ends in the axial direction; an uniaxial robot 142 that supports the support arm 140 so that the roll 135 performs relative movement along the surface of the wafer W; and a winding roll 144 that winds the peeling tape ST.

At a side position of the pay-out roll 132, a motor M6 capable to rotate both forward and reverse direction is disposed. Around the output shaft of the motor M6 and the shaft of the pay-out roll 132, pulleys 146 and 147 are fixed, between which a belt 149 is laid around; thus the pay-out roll 132 is arranged to rotate forward and reverse direction. The upper guide roll 133 is arranged to rotate by a motor M7, which is disposed at the rear face side of the supporting plate 130. And a pinch roll 151 is disposed at a position where the roll comes into contact with the periphery surface of the upper guide roll 133. The pinch roll 151 is arranged to move close to and away from upper guide roll 133 via a cylinder 153. The support arm 140 has a substantially L-like shape viewed from the top, and is arranged so that the one side thereof is movable along a rail 142A of the uniaxial robot 142.

The winding roll 144 is supported at the free end side of a swing arm 154. The swing arm 154 is supported at its base portion by a bracket 155 disposed at the lower portion of the base frame BF, and is arranged so that the free end side thereof is forced in the counterclockwise direction in Fig. 7 by a coil spring 156 disposed between the bracket 155 and a rotation arm 154 so as to come into contact with the periphery surface of a drive roll 158. On the rotating axis of the drive roll 158, an unshown pulley is fixed, and it is arranged the pulley rotates via a belt 161, which is laid around pulley 160 fixed to the output shaft of a motor M8 with brake and the unshown pulley. Reference numeral 162 in Fig. 7 denotes a guide roll.

Next, the entire operation of the wafer processing steps including a peeling method by the sheet peeling apparatus 50 will be described.

A wafer W with the protection tape PT stuck on the circuit plane thereof is transferred to the UV irradiation unit 13 by the robot 12, and is subjected to a predetermined UV processing. The wafer W after the UV cure processing is transferred to an alignment table 34 via the robot 12 again, and subjected to an alignment process. After that, the wafer W is transferred to the sticking table 40 via the robot 12 again. During this transfer, the protection tape PT is sucked in a state being in contact with the table. Accordingly, in this state, the rear surface of the wafer W comes to the upper side.

As shown in Fig. 3, when the sticking table 40 moves to a predetermined position of the sticking unit 41, the lead end area of the web material LS, which is sucked and held at the bottom face side of the pressurizing member 76 is brought into contact with the upper face of the sticking table 40 by the lowering operation of the pressurizing member 76. After the contact has been achieved, the press roll 78 lowers to pinch the web material LS between the upper face of the wafer W and the press roll 78, and the unnecessary portion of the web material S1 other than the area of the wafer W is brought into contact with the outer table section. Then, the pressurizing member 76 releases the suction and rises.

While the sticking table 40 moves rightward in Fig. 3 and the press roll 78 rotates, the adhesive sheet S of the web material LS paid-out successively is stuck on the upper face of the wafer W. During this sticking operation, the unnecessary portion of the web material S1 extruding out of the periphery of the wafer W is stuck to the outer table with a weak adhesive strength. Accordingly, while the press roll 78 rotates on the wafer W, the tension of the web material LS and the pressurizing force of the press roll 78 pressing force of the press roll 78 causes tensile force, which prevents a disadvantage of wrinkles. The press roll 78 is controlled to maintain to substantially 110 degree C by the heater as a built-in heating means.

As described above, when the adhesive sheet portion S of the web material LS is stuck on the wafer W and the pressurizing member 76 comes to a position above the cutter receiving groove 40A immediately after the pressurizing member 76 passes the same as shown Fig. 4, the sticking table 40 comes to a position substantially just above the periphery cutting table 47. Then, the pressurizing member 76 lowers to bring the web material LS into contact with the sticking table 40. Thereafter, the cutter 96 of the cutting means 43 enters into the cutter receiving groove 40A, and the arm 90 supporting the cutter unit 92 moves in the direction perpendicular to the figure plane of Fig. 4 to cut the web material LS in its width direction into a sheet-like shape. When this cutting operation is completed, the pressurizing member 76 sucks the web material LS positioned at the bottom face side of the pressurizing member 76 and returns to the upper end position to stand by for sticking the next wafer W. When the cylinder 95 for the cutter vertical movement rises, the cutting means 43 shifts to a position in which the position of the blade of the cutter 96 rises to retreat in the direction away from the position of the upper face of the sticking table 40; i.e., upward direction in Fig. 4.

Then, the suction plate 100 of the transfer unit 45 moves to a position above the sticking table 40 by the motion of the uniaxial robot 105 and the decent of the cylinder 106, and the position of the face of the suction plate 100 is lowered to suck and hold the wafer W, on which the web material LS has been stuck already. Accordingly, the sticking table 40 moves to the original position for sucking and holding a wafer W as a subsequent work piece (refer to Fig. 3). At the same time, the periphery cutting table 47 rises, and the wafer W sucked by the suction plate 100 is transferred to the upper face of the periphery cutting table 47. In this way, the wafer W, which has been heated temporarily to a sticking temperature by the sticking table 40, is subjected to a temperature control operation (cooling operation) while being sucked by the suction plate 100, and is maintained in a state being cooled down to the substantially ambient temperature.

When the wafer W is transferred to the periphery cutting table 47 and sucked and held, the transfer unit 45 moves in the direction away from the position above the periphery cutting table 47. On the other hand, the cutting means 43 moves to a position above the periphery cutting table 47. Then, the predetermined amount motion of uniaxial robot 91 and the descent of the cylinder 95 for cutter vertical movement, makes the cutter 96 penetrates to the rear side at a position substantially corresponding to the periphery edge of the wafer W and the extreme edge thereof is received within the circumference groove 47A. In this state, the periphery cutting table 47 is rotated within a horizontal plane by the rotary mechanism 110, and the unnecessary portion of the web material S1 extruding out of the periphery of the wafer W is cut along the periphery thereof (refer to Figs. 8(A) and (B)). When the cutting has completed, the cutting means 43 moves to a retreated position from the position above the periphery cutting table 47, and the sheet peeling apparatus 50 carries out the peeling operation as described below.

That is, in the sheet peeling apparatus 50, the roll 135 is in a state shown in Fig. 1, i.e., in a retreated position to the right as an initial position with respect to the periphery cutting table 47. And the roll 135 is arranged to proceed toward the periphery cutting table 47 via the uniaxial robot 142 in the peeling operation. When the roll 135 proceeds, the motor M6 rotates in the direction that the peeling tape ST is paid out, and a specific tension is given to the peeling tape ST between the upper guide roll 133 and the roll 135 by the motor M7. At this time, the motor M8 with brake is in a state that the brake is activated for locking. When the roll 135 reaches to the upper portion at the right end of the unnecessary portion of web material S1 (refer to Fig. 8(B)) the roll 135 descends via the cylinder 139; consequently the peeling tape ST is stuck to the release liner PS across the whole area thereof from the right to the left in Fig. 8(C) along the radial direction of the wafer W. That is, the peeling tape ST is stuck crossing the unnecessary portions S1 of web material and the release liner PS portion on the wafer W. Then, the motors M6 and M7 rotate in reverse direction and the roll 135 returns to the initial position while rotating in the opposite way to when sticking the peeling tape ST (refer to Fig. 8(D)). Thereby, the unnecessary portions of the web material S1 and the release liner PS on the wafer W are peeled off simultaneously (refer to Fig. 8(E)). And when the peeling operation is completed, the lock of the motor M8 with brake is released, and the motor rotates the drive roll 158. The unnecessary portions of the web material S1 and the release liner PS on the wafer W are wound toward the winding roll 144, and the pay-out roll 132 rotates in the pay-out direction of the web material LS. Thereby, the unnecessary portions or area of the web material LS peeled off by the peeling tape ST, is wound. As the winding operation proceeds, the rotation arm 154 swings to the direction indicated with the arrow in Fig. 7; thus the winding operation is carried out as indicated with the chain double-dashed line.

When the above peeling operation is completed, the transfer unit 45 moves to the position above the periphery-cutting table 47 and sucks the wafer W again. While raising the temperature to a temperature necessary for complete bonding via the temperature control unit, the transfer unit 45 transfers the wafer W to the upper face of the bonding table 48.

Since the bonding table 48 is controlled to maintain a third temperature of approximately 180°C, the wafer W transferred to the bonding table 48 is subjected to the operation to bond the adhesive sheet S completely thereto. After a predetermined period of time has elapsed, the suction plate 100 of the transfer unit 45 sucks the wafer W, and the wafer W is subjected to the temperature control operation to lower the temperature thereof to an ambient temperature again.

The wafer W, the temperature of which is lowered during the suction by the transfer unit 45, is transferred to the mount unit 18 and mounted on a ring frame RF via a dicing tape DT. Thereafter, the protection tape PT is peeled off and the wafer W is stored in the stocker; thus, the sequential operation of the wafer processing is completed. The process after the mounting operation is the identical to that disclosed in Japanese Patent Application No. 2004-133069.

According to the above-described embodiment of the present invention, such an arrangement is made that both of the release liner positioned on the wafer and the web material positioned in the periphery side are peeled off or removed simultaneously. Accordingly, the peeling operation can be carried out avoiding to introduce complicated apparatus, and the processing time for the wafer also can be reduced. Further, such an arrangement is adopted that, when sticking the adhesive sheet S to the wafer W by pressurizing force of the press roll, the adhesive sheet S is stuck in a state of the web material LS where the adhesive sheet S is laminated with the release liner PS; i.e., before the adhesive sheet S is stuck, the adhesive sheet S and the release liner PS are not separated from each other. Therefore, the sticking force is imparted in a state that the release liner PS is interposed between the press roll 78 and the adhesive sheet S. Accordingly, the adhesive sheet S is reliably prevented from being damaged by the press roll 78.

As described so far, the best structure and method for carrying out the present invention have been disclosed. However, the present invention is not limited to the above.
That is, the present invention has been illustrated and described about mainly a specific embodiment. However, if necessary, it is possible for a person skilled in the art to add various modifications to the above-described embodiment with respect to the shape, position or disposition without departing from the technical sprit and the range of the object of the present invention.

For example, in this embodiment, there has been described the case in which the web material LS of band-like shape laminated with the adhesive sheet S on one surface of the release liner PS is used. However the present invention is not limited to the above. It may be arranged in such a way that, by employing web material formed to a sheet-like shape beforehand, the adhesive sheet S is stuck to the wafer W and then unnecessary portion is peeled off.
Also, the structure and layout of the sheet peeling apparatus 50 may be arbitrarily modified, provided with the same operation can be obtained substantially.
Further, the adhesive sheet S is not limited to the sheet for die bonding, but may be a protection sheet to form a protection film through sticking.
Furthermore, the plate-like object is not limited to the semiconductor wafer, but may be an information-recording medium such as an optical disk and DVD. The shape of the plate-like object is not limited to a circular form, but may be a polygonal shape of a polarization plate and the like. As for the adhesive sheet for processing these plate-like objects, a double-sided adhesive sheet may be used.

## Claims

1. A sheet peeling apparatus, which, after paying out a web material laminated with an adhesive sheet on one surface of a release liner and sticking said adhesive sheet to a plate-like object, cuts the web material along the periphery of the plate-like object and peels off a release liner portion positioned on the plate-like object along with a web material portion positioned on the periphery side around the plate-like object, is provided with,
a stick and winding section for a peeling tape, wherein the stick and winding section winds the peeling tape in a state that the peeling tape is stuck crossing the release liner positioned on said plate-like object and the release liner positioned at said periphery side, whereby peels off simultaneously the release liner positioned on said plate-like object along with the web material portion positioned at said periphery side.

2. A sheet peeling apparatus, which, after paying out a web material continuing in a band-like shape laminated with a heat sensitive adhesive sheet on one surface of a release liner and sticking said adhesive sheet to a plate-like object, cuts the web material in the width direction to a sheet-like shape and cuts the web material along the periphery of the plate-like object, and peels off the release liner positioned on the plate-like object along with a web material portion positioned at the periphery side of the plate-like object, is provided with,
a stick and winding section for a peeling tape, wherein the stick and winding section winds the peeling tape in a state that the peeling tape is stuck crossing the release liner positioned on said plate-like object and the release liner positioned at said periphery side, whereby peels off simultaneously the release liner positioned on said plate-like object along with the web material portion positioned at said periphery side.

3. The sheet peeling apparatus according to claims 1 or 2, wherein said stick and winding section includes a roll capable of performing a relative movement with respect to a table supporting said plate-like object, the roll having a function to rotate on the web material to stick a peeling tape onto the release liner in a state that the peeling tape is wound on the periphery thereof, and a function to rotate in the opposite direction to said rotation to carry out said peeling operation.

4. The sheet peeling apparatus according to claims 1, 2 or 3, wherein said peeling tape is formed with a width smaller than the diameter of the plate-like object.

5. The sheet peeling apparatus according to claims 1, 2, 3 or 4, wherein said plate-like object is a semiconductor wafer.

6. A sheet peeling method, in which, after paying out a web material laminated with an adhesive sheet on one surface of a release liner and sticking said adhesive sheet to a plate-like object, the web material is cut along the periphery of the plate-like object and a release liner portion positioned on the plate-like object is peeled off along with a web material portion positioned on the periphery side around the plate-like object, comprising the steps of:
sticking step of a peeling tape crossing a release liner positioned on said plate-like object and a release liner positioned at said periphery side, and
peeling off step, through winding said peeling tape, of the release liner positioned on said plate-like object along with the web material positioned at said periphery side while winding simultaneously keeping the adhesive sheet left on said plate-like object.

7. The sheet peeling method according to claim 6, wherein said plate-like object is a semiconductor wafer.
